(19) Europäisches Patentamt / European Patent Office / Office européen des brevets

(11) **EP 3 576 270 A1**

(12) **EUROPÄISCHE PATENTANMELDUNG**

(43) Veröffentlichungstag:
04.12.2019 Patentblatt 2019/49

(51) Int Cl.:
*H02M 1/08* (2006.01)          *H02M 1/32* (2007.01)
*H03K 17/06* (2006.01)          *H02M 7/5387* (2007.01)
*H02M 1/00* (2006.01)          *H03K 17/08* (2006.01)

(21) Anmeldenummer: 18174871.6

(22) Anmeldetag: **29.05.2018**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Siemens Aktiengesellschaft**
**80333 München (DE)**

(72) Erfinder:
• **Bakran, Mark-Matthias**
**91052 Erlangen (DE)**
• **Böhmer, Jürgen**
**90547 Stein (DE)**
• **Helsper, Martin**
**90584 Allersberg (DE)**
• **Krafft, Eberhard Ulrich**
**90419 Nürnberg (DE)**
• **Laska, Bernd**
**91074 Herzogenaurach (DE)**
• **Nagel, Andreas**
**90431 Nürnberg (DE)**
• **Schönewolf, Stefan Hans Werner**
**90489 Nürnberg (DE)**
• **Weigel, Jan**
**91077 Großenbuch (DE)**

(54) **UMRICHTERBETRIEB MIT ERHÖHTER GATESTEUERSPANNUNG BEI HOHER SPERRSCHICHTTEMPERATUR**

(57) Eine Steuereinrichtung (8) eines Umrichters (1) nimmt getaktet jeweils einen Stromsollwert (I*) entgegen und ermittelt Schaltzeitpunkte (tij) für Schaltelemente (7) des Umrichters (1), so dass der Umrichter (1) einer Last (5) einen mit dem Stromsollwert (I*) korrespondierenden Strom (I) zuführt. Die Steuereinrichtung (8) nimmt Soll- oder Istgrößen (Ik) - entgegen und leitet daraus eine Sperrschichttemperatur (T) der Schaltelemente (7) ab. Die Steuereinrichtung (8) bleibt in einem Normalbetrieb, solange die Sperrschichttemperatur (T) unterhalb einer Grenztemperatur (TGO) bleibt. Anderenfalls wechselt sie in den Sonderbetrieb. Die Steuereinrichtung (8) bleibt im Sonderbetrieb, solange die Sperrschichttemperatur (T) oberhalb einer unteren Grenztemperatur (TGO) bleibt. Anderenfalls wechselt sie in den Normalbetrieb. Wenn die Sperrschichttemperatur (T) im Sonderbetrieb die obere Grenztemperatur (TGO) für längere Zeit erreicht oder überschreitet und/oder nach einem Absinken erneut erreicht oder überschreitet, modifiziert die Steuereinrichtung (8) die Schaltzeitpunkte (tij), so dass der der Last (5) zugeführte Strom (I) kleiner als der Stromsollwert (I*) ist. In beiden Modi sperrt die Steuereinrichtung (8) die Schaltelemente (7) zu den ermittelten Schaltzeitpunkten (tij) jeweils bzw. schaltet sie durch. Zum Sperren schaltet die Steuereinrichtung (8) in beiden Modi ein erstes Potenzial (P1) an eine Steuerelektrode (11) des jeweiligen Schaltelements (7) an, zum Durchschalten im Normalbetrieb ein zweites Potenzial (P2) und im Sonderbetrieb zumindest temporär ein drittes Potenzial (P3) und im Übrigen das zweite Potenzial (P2). Die Differenz des dritten Potenzials (P3) zum ersten Potenzial (P1) ist größer als die Differenz des zweiten Potenzials (P2) zum ersten Potenzial (P1).

FIG 5

**Beschreibung**

Die vorliegende Erfindung geht aus von einem Betriebsverfahren für einen eine Last speisenden Umrichter.

Derartige Betriebsverfahren sind allgemein bekannt. Üblicherweise nimmt die Steuereinrichtung getaktet jeweils einen Stromsollwert entgegennimmt und ermittelt Schaltzeitpunkte für Schaltelemente des Umrichters, zu denen die Steuereinrichtung die Schaltelemente alternierend sperrt und durchschaltet. Die Schaltelemente sind als Halbleiter-Bauelemente ausgebildet. Die Ermittlung der Schaltzeitpunkte erfolgt derart, dass der Umrichter der Last einen mit dem Stromsollwert korrespondierenden Strom zuführt. Weiterhin nimmt die Steuereinrichtung Soll- oder Istgrößen - meist Istgrößen - entgegen und leitet daraus eine Sperrschichttemperatur der Schaltelemente ab. Solange die Sperrschichttemperatur eine obere Grenztemperatur nicht erreicht oder überschreitet, behält die Steuereinrichtung die ermittelten Schaltzeitpunkte unverändert bei. Anderenfalls ermittelt sie die Schaltzeitpunkte derart neu, dass der der Last zugeführte Strom kleiner als der Stromsollwert ist. Die Steuereinrichtung sperrt die Schaltelemente zu den ermittelten Schaltzeitpunkten jeweils oder schaltet sie jeweils durch. Zum Sperren eines jeweiligen Schaltelements schaltet die Steuereinrichtung ein erstes Potenzial an eine Steuerelektrode des jeweiligen Schaltelements an, zum Durchschalten ein zweites Potenzial.

Die vorliegende Erfindung geht weiterhin aus von einem Steuerprogramm für eine Steuereinrichtung eines Umrichters, wobei das Steuerprogramm Maschinencode aufweist, der von der Steuereinrichtung abarbeitbar ist, wobei die Abarbeitung des Maschinencodes durch die Steuereinrichtung bewirkt, dass die Steuereinrichtung den Umrichter gemäß einem derartigen Betriebsverfahren betreibt.

Die vorliegende Erfindung geht weiterhin aus von einer Steuereinrichtung für einen Umrichter, wobei die Steuereinrichtung mit einem derartigen Steuerprogramm programmiert ist, so dass die Steuereinrichtung den Umrichter gemäß einem derartigen Betriebsverfahren betreibt.

Die vorliegende Erfindung geht weiterhin aus von einem Umrichter, wobei der Umrichter als Halbleiter-Bauelemente ausgebildete Schaltelemente aufweist, über die eine Last gespeist wird, wobei der Umrichter eine derartige Steuereinrichtung aufweist, welche den Umrichter gemäß einem derartigen Betriebsverfahren betreibt.

Bei einem Umrichter treten im durchgeschalteten Zustand an den Leistungshalbleitern des Umrichters Verluste auf. Aufgrund der Verluste erhöht sich die Sperrschichttemperatur des jeweiligen Halbleiters. Die Sperrschichttemperatur muss jedoch unterhalb eines kritischen Wertes gehalten werden, da anderenfalls der jeweilige Halbleiter und damit der Umrichter irreversibel zerstört würde.

Die am jeweiligen Halbleiterelement auftretende Verlustleistung ergibt sich durch das Produkt des von dem jeweiligen Halbleiterelement geführten Stromes mit der jeweiligen Durchlassspannung. Der Strom ist eine nichtlineare Funktion (Kennlinie) der Durchlassspannung, wobei die Funktion ihrerseits von der Steuerspannung des Halbleiters abhängig ist.

Wenn die Sperrschichttemperatur die Grenztemperatur erreicht oder überschritten wird, werden im Stand der Technik zum Schutz der Schaltelemente die ermittelten Schaltzeitpunkte derart neu ermittelt, dass der der Last zugeführte Strom kleiner als der Stromsollwert ist. Beispielsweise kann bei einer Pulsweitenmodulation der Anteil reduziert werden, zu dem die Schaltelemente durchgeschaltet sind. Dadurch fließt im Ergebnis ein geringerer Strom, wodurch die anfallende Verlustleistung entsprechend reduziert wird. Aufgrund des verringerten Stromes verringert sich weiterhin auch - wenn auch nur geringfügig - die Durchlassspannung, so dass die anfallende Verlustleistung noch weiter reduziert wird. Dadurch wird die Sperrschichttemperatur reduziert. Vorzugsweise erfolgt die Reduzierung des Stroms nur so weit, dass die Grenztemperatur gerade noch eingehalten wird.

Mit der Reduzierung des der Last zugeführten Stroms unter den Stromsollwert wird - wenn auch zum Schutz des Umrichters - der eigentlich gewünschte Betrieb der Last aufgegeben. Insbesondere wird die Last mit einer geringeren Leistung betrieben als eigentlich gewünscht. Beispielsweise ein Antrieb kann nur ein geringeres Moment als eigentlich gewünscht abgeben.

Die Aufgabe der vorliegenden Erfindung besteht darin, Möglichkeiten zu schaffen, mittels derer in einer Vielzahl von Anwendungsfällen der gewünschte Betrieb der Last aufrechterhalten werden kann, obwohl dies nicht möglich ist, wenn zum Sperren eines jeweiligen Schaltelements des Umrichters ein erstes Potenzial und zum Durchschalten des jeweiligen Schaltelements ein zweites Potenzial an eine Steuerelektrode des jeweiligen Schaltelements angeschaltet wird.

Die Aufgabe wird durch ein Betriebsverfahren mit den Merkmalen des Anspruchs 1 gelöst. Vorteilhafte Ausgestaltungen des Betriebsverfahrens sind Gegenstand der abhängigen Ansprüche 2 bis 8.

Erfindungsgemäß wird beim Betreiben des Umrichters zwischen einem Normalbetrieb und einem Sonderbetrieb unterschieden. Hierbei wird vorgeschlagen,

- dass die Steuereinrichtung im Normalbetrieb und im Sonderbetrieb getaktet jeweils einen Stromsollwert entgegennimmt und Schaltzeitpunkte für als Halbleiter-Bauelemente ausgebildete Schaltelemente des Umrichters, zu denen die Steuereinrichtung die Schaltelemente alternierend sperrt und durchschaltet, derart ermittelt, dass der Umrichter der Last einen mit dem Stromsollwert korrespondierenden Strom zuführt,

- dass die Steuereinrichtung im Normalbetrieb und im Sonderbetrieb Soll- oder Istgrößen - vorzugsweise Istgrößen - entgegennimmt und daraus eine Sperrschichttemperatur der Schaltelemente ableitet,
- dass die Steuereinrichtung, ausgehend vom Normalbetrieb, den Normalbetrieb beibehält, solange die Sperrschichttemperatur eine obere Grenztemperatur nicht erreicht oder überschreitet, und anderenfalls in den Sonderbetrieb übergeht,
- dass die Steuereinrichtung, ausgehend vom Sonderbetrieb, den Sonderbetrieb beibehält, solange die Sperrschichttemperatur eine untere Grenztemperatur nicht erreicht oder unterschreitet, und anderenfalls in den Normalbetrieb übergeht,
- dass die untere Grenztemperatur unter der oberen Grenztemperatur liegt,
- dass die Steuereinrichtung im Sonderbetrieb, wenn die Sperrschichttemperatur nach dem Übergang in den Sonderbetrieb nach einer Wartezeit immer noch bei oder oberhalb der oberen Grenztemperatur bleibt und/oder nach einem Absinken unter die obere Grenztemperatur die obere Grenztemperatur erneut erreicht oder überschreitet, die Schaltzeitpunkte derart neu ermittelt, dass der der Last zugeführte Strom kleiner als der Stromsollwert ist, und anderenfalls die ermittelten Schaltzeitpunkte unverändert beibehält,
- dass die Steuereinrichtung im Normalbetrieb und im Sonderbetrieb die Schaltelemente zu den ermittelten Schaltzeitpunkten jeweils sperrt oder durchschaltet,
- dass die Steuereinrichtung zum Sperren eines jeweiligen Schaltelements im Normalbetrieb und im Sonderbetrieb ein erstes Potenzial an eine Steuerelektrode des jeweiligen Schaltelements anschaltet,
- dass die Steuereinrichtung zum Durchschalten des jeweiligen Schaltelements im Normalbetrieb ein zweites Potenzial und im Sonderbetrieb zumindest temporär ein drittes Potenzial und im übrigen das zweite Potenzial an die Steuerelektrode des jeweiligen Schaltelements anschaltet und
- dass die Differenz des dritten Potenzials zum ersten Potenzial größer als die Differenz des zweiten Potenzials zum ersten Potenzial ist.

Solange die obere Grenztemperatur nicht erreicht oder überschritten wird, arbeitet die Steuereinrichtung also zunächst im Normalbetrieb so, wie dies allgemein bekannt ist. Bei Erreichen oder Überschreiten der oberen Grenztemperatur wird aber nicht sofort der der Last zugeführte Strom reduziert. Stattdessen geht die Steuereinrichtung in den Sonderbetrieb über, in dem die Steuereinrichtung zum Durchschalten des jeweiligen Schaltelements zumindest temporär ein drittes Potenzial an die Steuerelektrode des jeweiligen Schaltelements anschaltet, wobei das dritte Potenzial oberhalb des zweiten Potenzials liegt. Erst wenn die Sperrschichttemperatur trotz eines Übergangs vom Normalbetrieb in den Sonderbetrieb nicht absinkt oder nach einem derartigen Absinken im Sonderbetrieb die obere Grenztemperatur erneut erreicht oder überschreitet, wird der Strom reduziert.

Die vorliegende Erfindung beruht auf der Überlegung, dass durch das Erhöhen des Potenzials zum Durchschalten des jeweiligen Schaltelements die für den gleichen Strom erforderliche Durchlassspannung absinkt und dadurch auch die Verlustleistung entsprechend absinkt bzw. absinken müsste.

Durch das Erhöhen des Potenzials zum Durchschalten des jeweiligen Schaltelements wird zwar auch eine schnellere Alterung des Schaltelements bewirkt. Ein dauerhafter Betrieb des Umrichters im Sonderbetrieb würde daher zu einer vorzeitigen Alterung des Umrichters und dessen Ausfall führen. In einer Vielzahl von Anwendungsfällen wird die Last weit überwiegend jedoch nur in einem Teillastbetrieb betrieben, während die Volllast nur in einigen wenigen Betriebszuständen gefordert ist. Die schnellere Alterung zeigt in der Praxis daher nur geringe, praktisch vernachlässigbare Auswirkungen auf den Verschleiß des Umrichters.

Beispielsweise bei einem elektrisch betriebenen Straßenfahrzeug kann die Last der Traktionsantrieb des Straßenfahrzeugs sein. In diesem Fall wird Volllast nur bei extremen Beschleunigungsvorgängen oder einer Fahrt bergauf benötigt. Im Regelfall - insbesondere beispielsweise im Stadtverkehr und im Überlandverkehr - wird hingegen lediglich ein geringer Teil der Nennlast benötigt, oftmals weit unter 50 %. Analoge Sachverhalte gelten beispielsweise für elektrisch betriebene Schienenfahrzeuge. Auch hier wird ein Betrieb unter Volllast normalerweise nur benötigt, wenn kurzzeitig stark beschleunigt werden soll, insbesondere bei einer Fahrt bergauf. Während der übrigen Betriebszeiten hingegen arbeitet die Last nur mit einem Teil ihrer Nennlast, oftmals ebenfalls weit unter 50 %.

Es ist somit lediglich erforderlich, das dritte Potenzial derart zu wählen, dass das dritte Potenzial zwar einerseits einen hinreichenden Abstand zum zweiten Potenzial aufweist, so dass bei gleichem Strom die Durchlassspannung nennenswert niedriger ist, andererseits aber das dritte Potenzial noch so niedrig ist, dass das Schaltelement nicht direkt geschädigt wird. Eine entsprechende Festlegung des dritten Potenzials ist ohne weiteres möglich.

Es ist möglich, dass die Steuereinrichtung im Sonderbetrieb zum Durchschalten des jeweiligen Schaltelements ausschließlich das dritte Potenzial an die Steuerelektrode des jeweiligen Schaltelements anschaltet. Durch diese Vorgehensweise wird eine maximale thermische Entlastung der Sperrschicht der Schaltelemente erreicht.

Alternativ ist es möglich, dass die Steuereinrichtung im Sonderbetrieb zum Durchschalten des jeweiligen Schaltelements zunächst zum jeweiligen Schaltzeitpunkt das zweite Potenzial und erst danach das dritte Potenzial an die Steuerelektrode des jeweiligen Schaltelements anschaltet. Durch diese Vorgehensweise kann insbesondere erreicht werden, dass in dem - wenn auch seltenen - Fall eines lastseitigen Kurzschlusses der tatsächlich fließende Strom auf geringere Werte begrenzt werden kann, als wenn sofort das dritte Potenzial an die Steuerelektrode des jeweiligen Schaltelements angeschaltet würde. Auch in diesem Fall sollte jedoch das zweite Potenzial nur kurze Zeit verwendet werden. Bezogen auf den jeweiligen Zeitraum, zu dem das jeweilige Schaltelement durchgeschaltet ist, sollte also der Anteil, zu dem die Steuereinrichtung das dritte Potenzial an die Steuerelektrode des jeweiligen Schaltelements anschaltet, größer als der Anteil sein, zu dem die Steuereinrichtung das zweite Potenzial an die Steuerelektrode des jeweiligen Schaltelements anschaltet. Vorzugsweise liegt der Anteil, bezogen auf den Zeitraum zwischen dem Beginn und dem Ende des Durchschaltens des jeweiligen Schaltelements, bei mindestens 80 %, beispielsweise bei mindestens 90 %.

Um durch die Absenkung der Durchlassspannung eine nennenswerte Reduzierung der Verlustleistung zu bewirken, sollte das dritte Potenzial sich in hinreichendem Umfang von dem zweiten Potenzial unterscheiden. In der Praxis wird dies in der Regel dadurch erreicht, dass das dritte Potenzial, bezogen auf das erste Potenzial, um mindestens 10 % größer als das zweite Potenzial ist. Es sollte also die Beziehung

$$\frac{P3 - P1}{P2 - P1} > 1{,}1 \qquad\qquad (1)$$

gelten. Hierbei sind P1, P2 und P3 das erste, das zweite und das dritte Potenzial.

Vorzugsweise ist das dritte Potenzial, bezogen auf das erste Potenzial, um mindestens 20 % größer als das zweite Potenzial, insbesondere um mindestens 30 %.

Andererseits darf das dritte Potenzial nicht so hoch sein, dass sehr schnell eine Schädigung des Schaltelements auftritt. In der Praxis wird dies in der Regel dadurch erreicht, dass das dritte Potenzial, bezogen auf das erste Potenzial, um maximal 100 % größer als das zweite Potenzial ist. Es sollte also die Beziehung

$$\frac{P3 - P1}{P2 - P1} < 2{,}0 \qquad\qquad (2)$$

gelten. Vorzugsweise ist das dritte Potenzial, bezogen auf das erste Potenzial, um maximal 80 % größer als das zweite Potenzial, insbesondere um maximal 50 %.

In absoluten Zahlen ist das dritte Potenzial vorzugsweise um 3 V bis 10 V größer als das zweite Potenzial. Es sollte also vorzugsweise die Beziehung

$$3V < P3 - P2 < 10V \qquad\qquad (3)$$

gelten. Insbesondere kann das dritte Potenzial um 4 V bis 8 V über dem zweiten Potenzial liegen.

Das zweite Potenzial kann bei üblichen Werten liegen. In der Praxis wird in vielen Fällen das zweite Potenzial um 8 V bis 30 V größer als das erste Potenzial sein. Es sollte also vorzugsweise die Beziehung

$$8V < P2 - P1 < 30V \qquad\qquad (4)$$

gelten. Meist wird das zweite Potenzial um 12 V bis 20 V über dem ersten Potenzial liegen, beispielsweise bei 15 V, 17 V oder 18 V.

Die Aufgabe wird weiterhin durch ein Steuerprogramm mit den Merkmalen des Anspruchs 9 gelöst. Erfindungsgemäß bewirkt die Abarbeitung des Maschinencodes durch die Steuereinrichtung dass die Steuereinrichtung den Umrichter gemäß einem erfindungsgemäßen Betriebsverfahren betreibt.

Die Aufgabe wird weiterhin durch eine Steuereinrichtung für einen Umrichter mit den Merkmalen des Anspruchs 10 gelöst. Erfindungsgemäß ist die Steuereinrichtung mit einem erfindungsgemäßen Steuerprogramm programmiert, so dass die Steuereinrichtung den Umrichter gemäß einem erfindungsgemäßen Betriebsverfahren betreibt.

Die Aufgabe wird weiterhin durch einen Umrichter mit den Merkmalen des Anspruchs 11 gelöst. Erfindungsgemäß weist der Umrichter eine erfindungsgemäße Steuereinrichtung auf, welche den Umrichter gemäß einem erfindungsgemäßen Betriebsverfahren betreibt.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:

FIG 1            einen Umrichter und eine Last,
FIG 2            einen Ausschnitt von FIG 1,
FIG 3            ein Ablaufdiagramm,
FIG 4            ein Zeitdiagramm,
FIG 5            ein einzelnes Schaltelement und dessen Beschaltung und
FIG 6 bis 16     Zeitdiagramme.

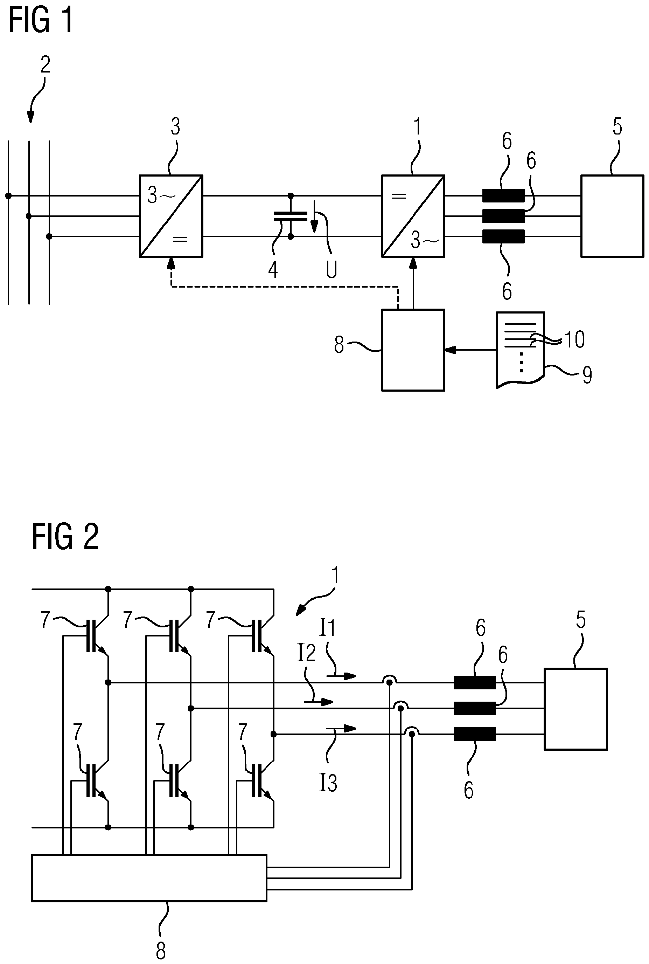

Gemäß FIG 1 wird ein Umrichter 1 aus einem Versorgungsnetz 2 gespeist. Beispielsweise kann entsprechend der Darstellung in FIG 1 der Umrichter 1 über einen Gleichrichter 3 mit dem Versorgungsnetz 2 verbunden sein. In diesem Fall ist zwischen dem Umrichter 1 und dem Gleichrichter 3 in der Regel ein Zwischenkreiskondensator 4 vorhanden. Alternativ kann der Umrichter 1 als Direktumrichter ausgebildet sein, der direkt mit dem Versorgungsnetz 2 verbunden ist. Auch andere Ausgestaltungen sind möglich. Beispielsweise kann der Umrichter 1 anstelle des Versorgungsnetzes 2 aus einer Batterie gespeist werden.

Über den Umrichter 1 wird eine Last 5 gespeist, also mit elektrischer Energie versorgt. Hierbei ist gewährleistet, dass das Anschalten der eingangsseitig des Umrichters 1 anstehenden Spannung U an die Last 5 nicht zu Stromstößen führt, sondern dass Stromanstiege und Stromabfälle geglättet werden. Beispielsweise können zu diesem Zweck zwischen dem Umrichter 1 und der Last 5 Drosseln 6 angeordnet sein. Es sind aber auch andere Ausgestaltungen möglich. Beispielsweise kann, wenn die Last 5 eine elektrische Maschine ist, die nötige Wirkung auch durch die Wicklungen der elektrischen Maschine als solche bewirkt werden.

Der Umrichter 1 weist gemäß FIG 2 Schaltelemente 7 auf. Die Schaltelemente 7 sind als Halbleiter-Bauelemente ausgebildet. Beispielsweise können die Schaltelemente 7 als IGBTs, als rückwärts leitfähige IGBTs oder als MOSFETs ausgebildet sein. Sie können als Si-Halbleiter (Si = Silizium) oder als SiC-Halbleiter (SiC = Siliziumcarbid) ausgebildet sein. Über die Schaltelemente 7 erfolgt das Anschalten der Spannung U an die Last 5. Falls die Spannung U zu hoch ist, um mittels eines einzelnen Schaltelements 7 geschaltet werden zu können, können die Schaltelemente 7 durch Reihenschaltungen entsprechender Schaltelemente realisiert sein, wobei die Schaltelemente der jeweiligen Reihenschaltung in der Regel simultan und gleichartig angesteuert werden.

Der Umrichter 1 weist eine Steuereinrichtung 8 auf. Die Steuereinrichtung 8 ist mit einem Steuerprogramm 9 programmiert. Das Steuerprogramm 9 umfasst Maschinencode 10, der von der Steuereinrichtung 8 abarbeitbar ist. Die Abarbeitung des Maschinencodes 10 durch die Steuereinrichtung 8 bewirkt, dass die Steuereinrichtung 8 den Umrichter 1 gemäß einem Betriebsverfahren betreibt, das nachstehend näher erläutert wird.

Gegebenenfalls steuert die Steuereinrichtung 8, wie in FIG 1 gestrichelt angedeutet ist, auch den Gleichrichter 1. Dies ist im Rahmen der vorliegenden Erfindung jedoch von untergeordneter Bedeutung.

Das erfindungsgemäße Betriebsverfahren wird in Verbindung mit einem einzelnen der Schaltelemente 7 erläutert. Es wird von der Steuereinrichtung 8 jedoch für alle Schaltelemente 7 ausgeführt.

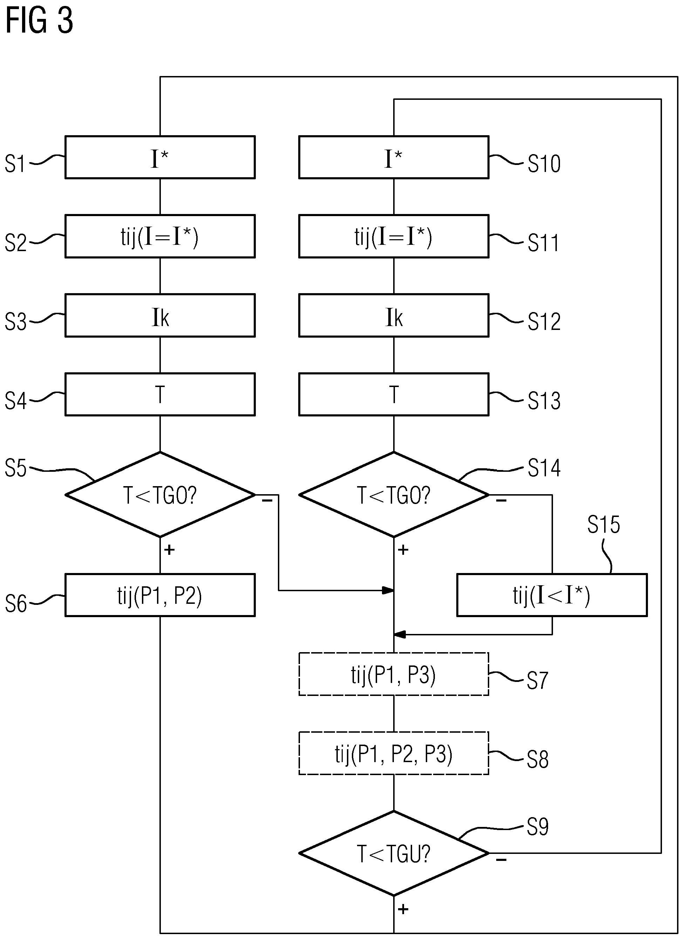

Die Steuereinrichtung 8 betreibt den Umrichter 1 alternativ in einem Normalbetrieb oder in einem Sonderbetrieb. FIG 3 zeigt in der linken Spalte den Normalbetrieb, in der rechten Spalte den Sonderbetrieb.

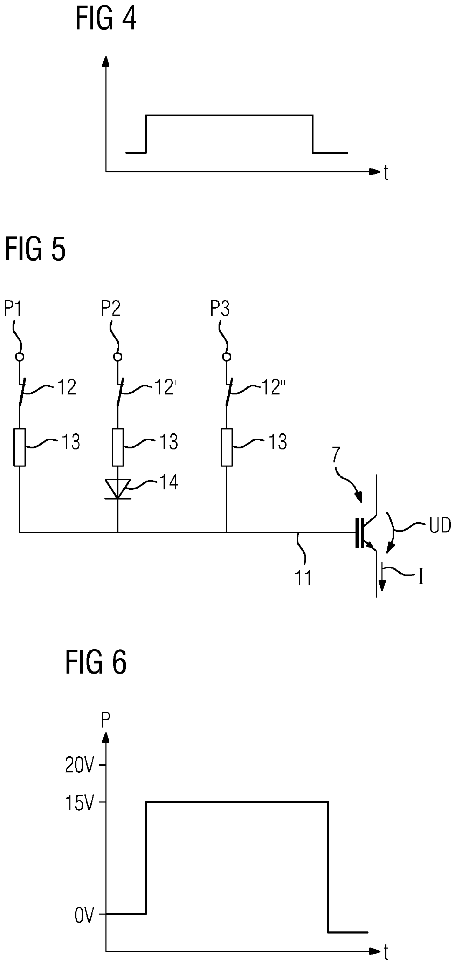

Im Normalbetrieb nimmt die Steuereinrichtung 8 in einem Schritt S1 einen Stromsollwert $I^*$ entgegen. In einem Schritt S2 ermittelt die Steuereinrichtung 8 sodann für die Schaltelemente 7 deren jeweilige Schaltzeitpunkte $t_{ij}$. Die Steuereinrichtung 8 ermittelt also - siehe FIG 4 - diejenigen Zeitpunkte $t_{ij}$, zu denen das jeweilige Schaltelement 7 durchgeschaltet werden soll bzw. gesperrt werden soll. Im durchgeschalteten Zustand leitet das jeweilige Schaltelement 7 Strom, im gesperrten Zustand nicht. Der Index i steht für die einzelnen Schaltelemente 7 (beispielsweise mit i = 1, ... 6) und der Index j für die einzelnen Schaltzeitpunkte des jeweiligen Schaltelements 7. Die Ermittlung des Schrittes S2 wird von der Steuereinrichtung 8 derart durchgeführt, dass ein Strom I (siehe FIG 5), der im durchgeschalteten Zustand durch das jeweilige Schaltelement 7 fließt, gleich dem jeweiligen Stromsollwert $I^*$ ist.

Die Schaltelemente 7 werden oftmals pulsweitenmoduliert gesteuert. Pulsweitenmodulation bedeutet, dass die Schaltzeitpunkte $t_{ij}$ derart ermittelt werden, dass in einem fest vorgegebenen Zeitraum - dem Kehrwert der Pulswiederholfrequenz - das entsprechende Schaltelement 7 während eines ersten Teils dieses Zeitraums durchgeschaltet wird und während eines zweiten Teils dieses Zeitraums gesperrt wird, wobei der erste und der zweite Teil zusammen den genannten Zeitraum ergeben. Wenn der erste Teil und der zweite Teil gleich groß sind, spricht man von einem duty cycle von 50 %. Wenn der erste Teil kleiner als der zweite Teil ist, liegt der duty cycle unter 50 %, im umgekehrten Fall über 50 %. Durch die Größe des duty cycle kann eingestellt werden, wie groß der Strom I ist. Die Steuereinrichtung 8 ermittelt somit im Ergebnis anhand des Stromsollwerts $I^*$ den erforderlichen duty cycle und bestimmt sodann anhand des duty cycle die Schaltzeitpunkte $t_{ij}$. Der Arbeitstakt kann mit dem Kehrwert der Pulswiederholfrequenz übereinstimmen. Alternativ kann der Arbeitstakt ein Vielfaches - insbesondere ein ganzzahliges Vielfaches des Kehrwerts der Pulswiederholfrequenz sein.

Im Normalbetrieb nimmt die Steuereinrichtung 8 weiterhin in einem Schritt S3 Soll- oder Istgrößen entgegen. Beispielsweise kann die Steuereinrichtung 8 - siehe FIG 2 - die der Last 5 zugeführten Phasenströme Ik entgegennehmen und dem jeweiligen Schaltelements 7 zuordnen. Der Index k steht hierbei für die jeweilige Phase (beispielsweise bei einem üblichen dreiphasigen Drehstromsystem mit k = 1 bis 3). In einem Schritt S4 leitet die Steuereinrichtung 8 aus den im Schritt S3 entgegengenommenen Größen eine Sperrschichttemperatur T des jeweiligen Schaltelements 7 ab. Beispielsweise kann die Steuereinrichtung 8 im Schritt S4 anhand eines Potenzials P2, das im Normalbetrieb zum Durchschalten des entsprechenden Schaltelements 7 an eine Steuerelektrode 11 des Schaltelements 7 - siehe FIG 5 - angeschaltet wird, in Verbindung mit dem Strom I die Durchlassspannung UD ermitteln, die in diesem Zustand über dem entsprechenden Schaltelement 7 abfällt. Das Produkt der Durchlassspannung UD mit dem Strom I ergibt dann die anfallende Verlustleistung. Aus der Verlustleistung kann die Sperrschichttemperatur T abgeleitet werden. Alternativ ist es beispielsweise möglich, dass die Steuereinrichtung 8 eine auf eine vorbestimmte Zeiteinheit (beispielsweise 1 s) bezogene Menge und eine Temperatur eines Kühlmediums entgegennimmt, mit dem die Schaltelemente 7 gekühlt werden, und daraus die Sperrschichttemperatur T ermittelt. Auch andere Vorgehensweisen sind möglich.

In einem Schritt S5 prüft die Steuereinrichtung 8, ob die ermittelte Sperrschichttemperatur T unterhalb einer oberen Grenztemperatur TGO bleibt. Die obere Grenztemperatur TGO ist in Abhängigkeit von den verwendeten Schaltelementen 7 nach Bedarf bestimmt. Beispielsweise kann sie bei 150 °C liegen.

Wenn und solange die ermittelte Sperrschichttemperatur T unterhalb der oberen Grenztemperatur TGO bleibt (= JA-Zweig des Schrittes S5), behält die Steuereinrichtung 8 den Normalbetrieb bei. Insbesondere geht die Steuereinrichtung 8 in diesem Fall zu einem Schritt S6 über. Im Schritt S6 steuert die Steuereinrichtung 8 das entsprechende Schaltelement 7 derart an, dass das entsprechende Schaltelement 7 zu den ermittelten Schaltzeitpunkten tij jeweils sperrt oder durchschaltet. Zu jedem Schaltzeitpunkt tij ändert das Schaltelement 7 also seinen Ansteuerzustand. Vom Schritt S6 aus geht die Steuereinrichtung 8 zum Schritt S1 zurück.

Zum Sperren des Schaltelements 7 schaltet die Steuereinrichtung 8 entsprechend der Darstellung in den FIG 4 bis 7 ein erstes Potenzial P1 an die Steuerelektrode 11 an, zum Durchschalten ein zweites Potenzial P2. Das zweite Potenzial P2 ist in der Regel um 8 V bis 30 V größer als das erste Potenzial P1, insbesondere um 10 V bis 20 V. Beispielsweise kann entsprechend der Darstellung in FIG 6 das erste Potenzial P1 bei 0 V liegen, das zweite Potenzial P2 bei 15 V.

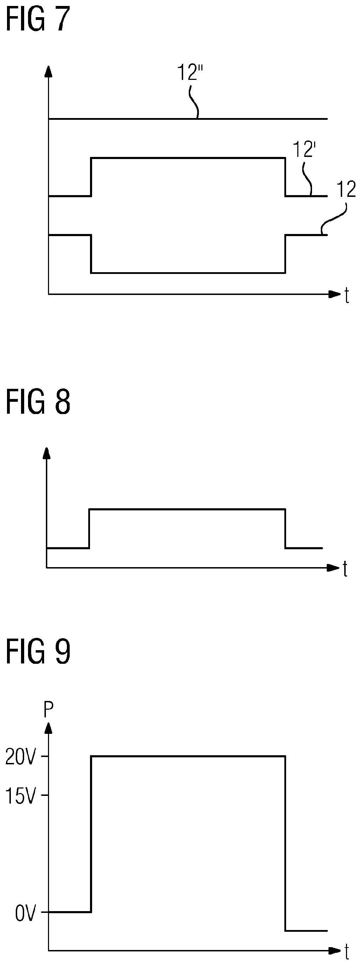

FIG 4 zeigt bezüglich eines der Schaltelemente 7 zwei unmittelbar aufeinanderfolgende Schaltzeitpunkte tij, wobei das entsprechende Schaltelement 7 zum früheren Schaltzeitpunkt tij durchgeschaltet und zum späteren Schaltzeitpunkt gesperrt wird. FIG 6 zeigt den zugehörigen zeitlichen Verlauf des an der Steuerelektrode 11 des entsprechenden Schaltelements 7 anstehenden Potenzials P als Funktion der Zeit t. FIG 7 zeigt die zugehörigen Schaltstellungen von Schaltern 12, 12' und 12'', mittels derer die Potenziale P1, P2 und ein weiteres Potenzial P3 an die entsprechende Steuerelektrode 11 angeschaltet werden.

Die in FIG 5 ebenfalls eingezeichneten Widerstände 13 sind von untergeordneter Bedeutung. Sie dienen lediglich dazu, bei der Änderung des Ansteuerzustands, also bei einer Änderung des der jeweiligen Steuerelektrode 11 zugeführten Potenzials P, sprunghafte Übergänge abzufedern. Im stabilen Zustand liegt an der jeweiligen Steuerelektrode 11 stets das jeweilige Potenzial P1, P2 bzw. P3 an.

Die Ausgestaltung der Beschaltung von FIG 5 als solche ist rein beispielhaft zu verstehen. Es sind ebenso auch andere Beschaltungen mit gleicher Wirkung möglich.

Wenn die Steuereinrichtung 8 im Schritt S5 hingegen feststellt, dass die Sperrschichttemperatur T die obere Grenztemperatur TGO erreicht oder gar überschreitet (= NEIN-Zweig des Schrittes S5), geht die Steuereinrichtung 8 in den Sonderbetrieb über. Insbesondere geht die Steuereinrichtung 8 zu einem Schritt S7 oder zu einem Schritt S8 über. Die Schritte S7 und S8 sind in FIG 3 gestrichelt eingezeichnet, weil von den Schritten S7 und S8 nur einer vorhanden ist, also entweder der Schritt S7 oder der Schritt S8.

Im Schritt S7 steuert die Steuereinrichtung 8 - analog zum Schritt S6 - das entsprechende Schaltelement 7 derart an, dass das entsprechende Schaltelement 7 zu den ermittelten Schaltzeitpunkten tij jeweils sperrt oder durchschaltet. Zu jedem Schaltzeitpunkt tij ändert das Schaltelement 7 also seinen Ansteuerzustand.

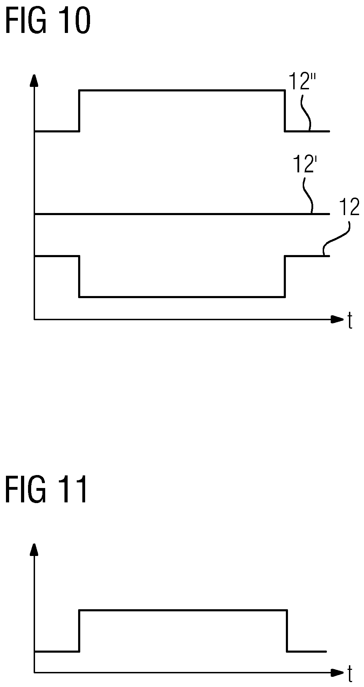

Zum Sperren des Schaltelements 7 schaltet die Steuereinrichtung 8 - analog zum Schritt S6 - entsprechend der Darstellung in den FIG 8 bis 10 das erste Potenzial P1 an die Steuerelektrode 1 an, zum Durchschalten aber anstelle des zweiten Potenzials P2 das dritte Potenzial P3. FIG 8 zeigt bezüglich eines der Schaltelemente 7 zwei unmittelbar aufeinanderfolgende Schaltzeitpunkte tij, wobei das entsprechende Schaltelement 7 zum früheren Schaltzeitpunkt tij durchgeschaltet und zum späteren Schaltzeitpunkt gesperrt wird. FIG 9 zeigt den zugehörigen zeitlichen Verlauf des an der Steuerelektrode 11 des entsprechenden Schaltelements 7 anstehenden Potenzials P als Funktion der Zeit t. FIG 10 zeigt die zugehörigen Schaltstellungen der Schalter 12, 12' und 12''.

Ersichtlich ist das dritte Potenzial P3 größer als das zweite Potenzial P2. Beispielsweise kann das dritte Potenzial P3 entsprechend der Darstellung in FIG 9 bei 20 V liegen. Unabhängig vom konkreten Wert des zweiten und des dritten Potenzials P2, P3 ist die Differenz des dritten Potenzials P3 zum ersten Potenzial P1 jedoch größer als die Differenz des zweiten Potenzials P2 zum ersten Potenzial P1.

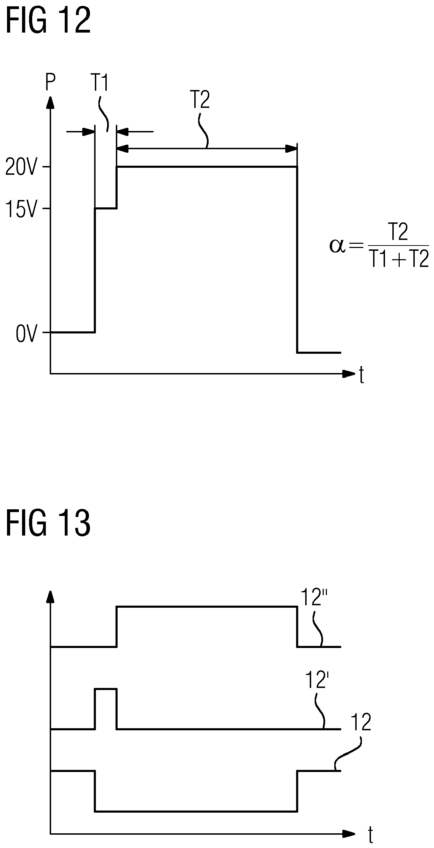

Auch im Schritt S8 steuert die Steuereinrichtung 8 - erneut analog zum Schritt S6 - das entsprechende Schaltelement 7 derart an, dass das entsprechende Schaltelement 7 zu den ermittelten Schaltzeitpunkten tij jeweils sperrt oder durchschaltet. Zu jedem Schaltzeitpunkt tij ändert das Schaltelement 7 also seinen Ansteuerzustand. Zum Sperren des Schaltelements 7 schaltet die Steuereinrichtung 8 - erneut analog zum Schritt S6 - entsprechend der Darstellung in den FIG 11 bis 13 das erste Potenzial P1 an die Steuerelektrode 1 an, zum Durchschalten aber nur temporär das dritte Potenzial P3 und ansonsten das zweite Potenzial P2. FIG 11 zeigt bezüglich eines der Schaltelemente 7 zwei unmittelbar aufeinanderfolgende Schaltzeitpunkte tij, wobei das entsprechende Schaltelement 7 zum früheren Schaltzeitpunkt tij durchgeschaltet und zum späteren Schaltzeitpunkt gesperrt wird. FIG 12 zeigt den zugehörigen zeitlichen Verlauf des an der Steuerelektrode 11 des entsprechenden Schaltelements 7 anstehenden Potenzials P als Funktion der Zeit t. FIG 13 zeigt die zugehörigen Schaltstellungen der Schalter 12, 12' und 12".

Gemäß der Darstellung in FIG 13 wird zum Wechseln vom zweiten Potenzial P2 zum dritten Potenzial P3 der Schalter 12' simultan zum Schalter 12" betätigt. Der Schalter 12' wird also zum gleichen Zeitpunkt geöffnet, zu dem der Schalter 12" geschlossen wird. Es ist bei geeigneter Ausgestaltung der Beschaltung der Steuerelektrode 11 jedoch ebenso möglich, den Schalter 12' geschlossen zu halten und ihn erst zu einem späteren Zeitpunkt zu öffnen. Beispielsweise kann zu diesem Zweck an geeigneter Stelle der Beschaltung eine Diode 14 angeordnet werden.

Der Unterschied des Schrittes S8 zum Schritt S7 besteht also darin, dass die Steuereinrichtung 5 im Schritt S7 zum Durchschalten des jeweiligen Schaltelements 7 ausschließlich das dritte Potenzial P3 an die Steuerelektrode 11 des jeweiligen Schaltelements 7 anschaltet, während die Steuereinrichtung 5 im Schritt S8 das dritte Potenzial P3 nur temporär und im übrigen das zweite Potenzial P2 an die Steuerelektrode 11 des jeweiligen Schaltelements 7 anschaltet. Hierbei wird im Rahmen des Schrittes S8 zum Durchschalten des jeweiligen Schaltelements 7 zunächst zum jeweiligen Schaltzeitpunkt tij das zweite Potenzial P2 und erst danach das dritte Potenzial P3 an die Steuerelektrode 11 des jeweiligen Schaltelements 7 angeschaltet.

Der Zeitraum T1, während dessen im Rahmen des Schrittes S8 das zweite Potenzial P2 an die Steuerelektrode 11 des jeweiligen Schaltelements 7 angeschaltet wird, sollte kleiner als der Zeitraum T2 sein, während dessen im Rahmen des Schrittes S8 das dritte Potenzial P3 an die Steuerelektrode 11 des jeweiligen Schaltelements 7 angeschaltet wird. Wenn mit

$$\alpha = \frac{T2}{T1 + T2} \qquad (5)$$

der Anteil $\alpha$ bezeichnet wird, zu dem - bezogen auf den gesamten Zeitraum, zu dem das entsprechende Schaltelement 7 jeweils durchgeschaltet ist, also die Pulsweite - das dritte Potenzial P3 an die Steuerelektrode 11 des jeweiligen Schaltelements 7 angeschaltet wird, so sollte der Anteil $\alpha$ vorzugsweise mindestens einen Wert von 0,8 aufweisen, besser sogar von mindestens 0,9.

Vom Schritt S7 bzw. S8 geht die Steuereinrichtung 8 zu einem Schritt S9 über. Im Schritt S9 prüft die Steuereinrichtung 8, ob die ermittelte Sperrschichttemperatur T unter eine untere Grenztemperatur TGU sinkt. Die untere Grenztemperatur TGU kann nach Bedarf bestimmt sein. Sie muss aber unter der oberen Grenztemperatur TGO liegen. Beispielsweise kann die untere Grenztemperatur TGU bei 130 °C liegen.

Wenn und solange die ermittelte Sperrschichttemperatur T oberhalb der unteren Grenztemperatur TGU bleibt (= NEIN-Zweig des Schrittes S9), behält die Steuereinrichtung 8 den Sonderbetrieb bei. Insbesondere geht die Steuereinrichtung 8 in diesem Fall zu einem Schritt S10 über. Anderenfalls - also im JA-Zweig des Schrittes S9 - geht die Steuereinrichtung 8 zum Schritt S1 und damit in den Normalbetrieb über.

Im Schritt S10 nimmt die Steuereinrichtung 8 einen Stromsollwert I* entgegen. In einem nachfolgenden Schritt S11 ermittelt die Steuereinrichtung 8 für die Schaltelemente 7 deren jeweilige Schaltzeitpunkte tij. Sodann nimmt die Steuereinrichtung 8 in einem Schritt S12 Soll- oder Istgrößen entgegen und leitet daraus einem Schritt S13 die Sperrschichttemperatur T des jeweiligen Schaltelements 7 ab. Die Schritte S10 bis S13 korrespondieren inhaltlich mit den Schritten S1 bis S4 des Normalbetriebs. Der Unterschied besteht darin, dass im Schritt S13 der Ermittlung der Sperrschichttemperatur T gegebenenfalls anstelle des zweiten Potenzials P2 das dritte Potenzial P3 und die daraus resultierende Änderung der Durchlassspannung UD des jeweiligen Schaltelements 7 zugrunde gelegt wird.

In einem Schritt S14 prüft die Steuereinrichtung 8, ob die ermittelte Sperrschichttemperatur T die obere Grenztemperatur TGO erreicht oder gar überschreitet. Wenn dies der Fall ist (= JA-Zweig des Schrittes S14), geht die Steuereinrichtung 8 zu einem Schritt S15 über. Im Schritt S15 ermittelt die Steuereinrichtung 8 die Schaltzeitpunkte tij neu. Die Ermittlung des Schrittes S15 ist derart, dass der der Last 5 zugeführte Strom (genauer: im Regelfall die Phasenströme Ik) kleiner als der Stromsollwert I* ist. Im Falle einer Pulsweitenmodulation kann die Steuereinrichtung 8 die Schaltzeitpunkte tij beispielsweise auf Basis eines duty cycle unterhalb des duty cycle bestimmen, der zum Erreichen des Stromsollwerts I* erforderlich ist. Anderenfalls, also im NEIN-Zweig des Schrittes S14, überspringt die Steuereinrichtung 8 den Schritt S15. In diesem Fall geht die Steuereinrichtung 8 direkt zum Schritt S7 bzw. zum Schritt S8 über. Sie behält also in diesem Fall die im Schritt S11 ermittelten Schaltzeitpunkte tij unverändert bei.

Die Darstellung des Schrittes S14 in FIG 3 ist etwas vergrößert. Konkret ist der Schritt S14 derart ausgestaltet, dass nach dem Wechsel vom Normalbetrieb in den Sonderbetrieb zunächst eine Wartezeit abgewartet wird. Die Wartezeit kann beispielsweise zwischen 1 und 10 Sekunden liegen. Innerhalb der Wartezeit wird die Ausführung des Schrittes S15 gesperrt. Die Schaltzeitpunkte tij werden während der Wartezeit also auch dann unverändert beibehalten, wenn die Sperrschichttemperatur T während der Wartezeit bei oder oberhalb der oberen Grenztemperatur TGO bleibt. Es wird also abgewartet, ob der Übergang vom Normalbetrieb in den Sonderbetrieb eine hinreichende Wirkung zeigt. Wenn hingegen die Wartezeit abgelaufen ist und die Sperrschichttemperatur T im Sonderbetrieb immer noch bei oder oberhalb der oberen Grenztemperatur TGO bleibt, wird der Schritt S15 ausgeführt, so dass die Schaltzeitpunkte tij in entsprechend modifizierter Form ermittelt werden.

Es ist weiterhin möglich, dass die Steuereinrichtung 8 im Schritt S14 prüft, ob die Sperrschichttemperatur T im Sonderbetrieb zunächst abgesunken ist und erst danach, also nach dem Absinken, erneut die obere Grenztemperatur TGO erneut erreicht oder überschreitet. Auch in diesem Fall geht die Steuereinrichtung 8 vom Schritt S14 zum Schritt S15 über, gegebenenfalls sogar innerhalb der Wartezeit.

Aus den obigen Ausführungen ist ersichtlich, dass die Steuereinrichtung 8 die Schritte S1 bis S15 zyklisch ausführt. In der Regel erfolgt eine getaktete Ausführung, dass also die Steuereinrichtung 8 mit einem Arbeitstakt jeweils einen der Schritte S1 bzw. S10 und die jeweils darauffolgenden Schritte S2 bis S6 bzw. S11 bis S15 sowie S7 bis S9 ausführt. Der Arbeitstakt liegt in der Regel im Mikrosekundenbereich, in manchen Fällen auch im Bereich weniger Millisekunden.

Im Rahmen der obigen Ausführungen ist weiterhin vorgesehen, dass die Steuereinrichtung 8 in jedem Arbeitstakt vom Normalbetrieb in den Sonderbetrieb oder umgekehrt wechseln kann. Es ist jedoch möglich, bei einem Wechsel jeweils eine Sperre zu setzen, so dass nicht sofort wieder in den ursprünglichen Betrieb zurück gewechselt werden kann. Die Sperre kann beispielsweise für eine vorbestimmte Zeit - beispielsweise im einstelligen Sekundenbereich - oder für eine vorbestimmte Anzahl von Arbeitstakten gesetzt sein.

Im Rahmen der bisherigen Erläuterungen - insbesondere der Ausgestaltung gemäß FIG 5 - ist weiterhin das dritte Potenzial P3 konstant. Bei geeigneter Auslegung der Beschaltung ist es jedoch möglich, das Potenzial, das zum Durchschalten an die Steuerelektrode 11 angeschaltet wird, im Sonderbetrieb ausgehend vom zweiten Potenzial P2 kontinuierlich bis auf einen Maximalwert zu erhöhen. Eine derartige Ausgestaltung weist den Vorteil auf, dass bei Überschreiten der oberen Grenztemperatur TGO das zum Durchschalten des jeweiligen Schaltelements 7 an die Steuerelektrode 11 des jeweiligen Schaltelements 7 angeschaltete Potenzial nur so weit über das zweite Potenzial P2 angehoben werden muss, dass die obere Grenztemperatur TGO gerade noch eingehalten wird.

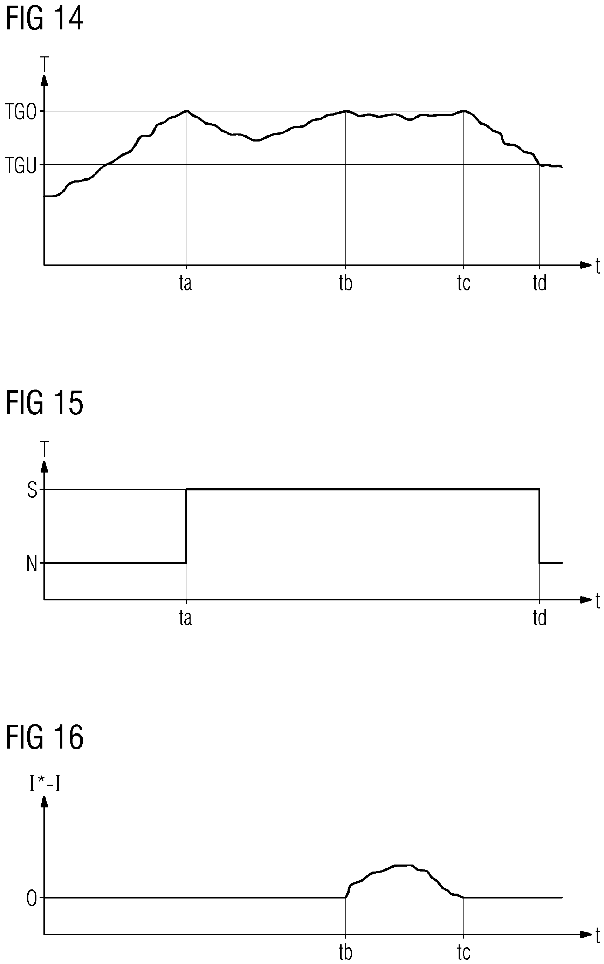

Die erfindungsgemäße Vorgehensweise wird kurz nochmals in Verbindung mit den FIG 14 bis 16 näher erläutert.

FIG 14 zeigt einen möglichen Verlauf der Sperrschichttemperatur T als Funktion der Zeit t. FIG 15 zeigt den korrespondierenden Betriebszustand als Funktion der Zeit t, wobei N für den Normalbetrieb und S für den Sonderbetrieb steht. FIG 16 zeigt die Differenz zwischen dem über die Schaltzeitpunkte tij eingestellten Strom I und dem Stromsollwert I*, ebenfalls als Funktion der Zeit.

Gemäß den FIG 14 bis 16 ist die Sperrschichttemperatur T zunächst kleiner als die obere Grenztemperatur TGO. Die Steuereinrichtung 8 betreibt den Umrichter 1 im Normalbetrieb. Zu einem Zeitpunkt ta erreicht die Sperrschichttemperatur T die obere Grenztemperatur TGO. Die Steuereinrichtung 8 wechselt aufgrund dieses Sachverhalts in den Sonderbetrieb. Aufgrund des Sonderbetriebs sinkt die Sperrschichttemperatur T wieder ab. Aufgrund einer längeren Anforderung einer hohen Leistung und damit eines hohen Stromsollwertes I* kann jedoch auch im Sonderbetrieb die Sperrschichttemperatur T wieder ansteigen und zu einem Zeitpunkt tb die obere Grenztemperatur TGO erreichen. Ab dem Zeitpunkt tb ermittelt die Steuereinrichtung 8 die Schaltzeitpunkte tij daher derart, dass der tatsächlich eingestellte Strom I unter dem Stromsollwert I* liegt. Später sinkt die angeforderte Leistung wieder ab. Dadurch sinkt auch die Sperrschichttemperatur T, so dass die Steuereinrichtung 8 die Schaltzeitpunkte tij ab einem Zeitpunkt tc wieder derart ermitteln kann, dass der tatsächlich eingestellte Strom I gleich dem Stromsollwert I* ist. Zu einem Zeitpunkt td unterschreitet die Sperrschichttemperatur T die untere Grenztemperatur TGU. Die Steuereinrichtung 8 wechselt deshalb wieder in den Normalbetrieb.

Zusammengefasst betrifft die vorliegende Erfindung somit folgenden Sachverhalt:

Eine Steuereinrichtung 8 eines Umrichters 1 nimmt getaktet jeweils einen Stromsollwert I* entgegen und ermittelt Schaltzeitpunkte tij für Schaltelemente 7 des Umrichters 1, so dass der Umrichter 1 einer Last 5 einen mit dem Stromsollwert I* korrespondierenden Strom I zuführt. Die Steuereinrichtung 8 nimmt Soll- oder Istgrößen Ik - entgegen und leitet daraus eine Sperrschichttemperatur T der Schaltelemente 7 ab. Die Steuereinrichtung 8 bleibt in einem Normalbetrieb, solange die Sperrschichttemperatur T unterhalb einer Grenztemperatur TGO bleibt. Anderenfalls wechselt sie in den Sonderbetrieb. Die Steuereinrichtung 8 bleibt im Sonderbetrieb, solange die Sperrschichttemperatur T oberhalb einer unteren Grenztemperatur TGO bleibt. Anderenfalls wechselt sie in den Normalbetrieb. Wenn die Sperrschichttemperatur T im Sonderbetrieb die obere Grenztemperatur TGO für längere Zeit erreicht oder überschreitet und/oder nach einem Absinken erneut erreicht oder überschreitet, modifiziert die Steuereinrichtung 8 die Schaltzeitpunkte tij, so dass der der Last 5 zugeführte Strom I kleiner als der Stromsollwert I* ist. In beiden Modi sperrt die Steuereinrichtung 8 die Schaltelemente 7 zu den ermittelten Schaltzeitpunkten tij jeweils bzw. schaltet sie durch. Zum Sperren schaltet die Steuereinrichtung 8 in beiden Modi ein erstes Potenzial P1 an eine Steuerelektrode 11 des jeweiligen Schaltelements 7 an, zum Durchschalten im Normalbetrieb ein zweites Potenzial P2 und im Sonderbetrieb zumindest temporär ein drittes Potenzial P3 und im übrigen das zweite Potenzial P2. Die Differenz des dritten Potenzials P3 zum ersten Potenzial P1 ist größer als die Differenz des zweiten Potenzials P2 zum ersten Potenzial P1.

Die vorliegende Erfindung weist viele Vorteile auf. Insbesondere können die in den Schaltelementen 7 auftretenden Verluste temporär reduziert werden und dadurch temporär eine höhere Ausgangsleistung des Umrichters 1 erreicht werden. Dadurch ist ein Betrieb mit erhöhtem Strombedarf für längere Zeit möglich. Dennoch wird die Lebensdauer des Umrichters 1 nicht oder nur in vernachlässigbarem Umfang reduziert.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

**Patentansprüche**

1.    Betriebsverfahren für einen eine Last (5) speisenden Umrichter (1),

- wobei eine Steuereinrichtung (8) den Umrichter (1) in einem Normalbetrieb oder in einem Sonderbetrieb betreibt,
- wobei die Steuereinrichtung (8) im Normalbetrieb und im Sonderbetrieb getaktet jeweils einen Stromsollwert (I*) entgegennimmt und Schaltzeitpunkte (tij) für als Halbleiter-Bauelemente ausgebildete Schaltelemente (7) des Umrichters (1), zu denen die Steuereinrichtung (8) die Schaltelemente (7) alternierend sperrt und durchschaltet, derart ermittelt, dass der Umrichter (1) der Last (5) einen mit dem Stromsollwert (I*) korrespondierenden Strom (I) zuführt,
- wobei die Steuereinrichtung (8) im Normalbetrieb und im Sonderbetrieb Soll- oder Istgrößen (Ik) - vorzugsweise Istgrößen (Ik) - entgegennimmt und daraus eine Sperrschichttemperatur (T) der Schaltelemente (7) ableitet,
- wobei die Steuereinrichtung (8), ausgehend vom Normalbetrieb, den Normalbetrieb beibehält, solange die Sperrschichttemperatur (T) eine obere Grenztemperatur (TGO) nicht erreicht oder überschreitet, und anderenfalls in den Sonderbetrieb übergeht,
- wobei die Steuereinrichtung (8), ausgehend vom Sonderbetrieb, den Sonderbetrieb beibehält, solange die Sperrschichttemperatur (T) eine untere Grenztemperatur (TGO) nicht erreicht oder unterschreitet, und anderenfalls in den Normalbetrieb übergeht,
- wobei die untere Grenztemperatur (TGU) unter der oberen Grenztemperatur (TGO) liegt,
- wobei die Steuereinrichtung (8) im Sonderbetrieb, wenn die Sperrschichttemperatur (T) nach dem Übergang in den Sonderbetrieb nach einer Wartezeit immer noch bei oder oberhalb der oberen Grenztemperatur (TGO) bleibt und/oder nach einem Absinken unter die obere Grenztemperatur (TGO) die obere Grenztemperatur (TGO) erneut erreicht oder überschreitet, die Schaltzeitpunkte (tij) derart neu ermittelt, dass der der Last (5) zugeführte Strom (i) kleiner als der Stromsollwert (I*) ist, und anderenfalls die ermittelten Schaltzeitpunkte (tij) unverändert beibehält,
- wobei die Steuereinrichtung (8) im Normalbetrieb und im Sonderbetrieb die Schaltelemente (7) zu den ermittelten Schaltzeitpunkten (tij) jeweils sperrt oder durchschaltet,
- wobei die Steuereinrichtung (8) zum Sperren eines jeweiligen Schaltelements (7) im Normalbetrieb und im Sonderbetrieb ein erstes Potenzial (P1) an eine Steuerelektrode (11) des jeweiligen Schaltelements (7) anschaltet,
- wobei die Steuereinrichtung (8) zum Durchschalten des jeweiligen Schaltelements (7) im Normalbetrieb ein zweites Potenzial (P2) und im Sonderbetrieb zumindest temporär ein drittes Potenzial (P3) und im Übrigen das zweite Potenzial (P2) an die Steuerelektrode (11) des jeweiligen Schaltelements (7) anschaltet und
- wobei die Differenz des dritten Potenzials (P3) zum ersten Potenzial (P1) größer als die Differenz des zweiten Potenzials (P2) zum ersten Potenzial (P1) ist.

2.    Betriebsverfahren nach Anspruch 1,
**dadurch gekennzeichnet,**
**dass** die Steuereinrichtung (8) im Sonderbetrieb zum Durchschalten des jeweiligen Schaltelements (7) ausschließlich das dritte Potenzial (P3) an die Steuerelektrode (11) des jeweiligen Schaltelements (7) anschaltet.

3.    Betriebsverfahren nach Anspruch 1,

**dadurch gekennzeichnet,**
**dass** die Steuereinrichtung (8) im Sonderbetrieb zum Durchschalten des jeweiligen Schaltelements (7) zunächst zum jeweiligen Schaltzeitpunkt (tij) das zweite Potenzial (P2) und erst danach das dritte Potenzial (P3) an die Steuerelektrode (11) des jeweiligen Schaltelements (7) anschaltet.

4. Betriebsverfahren nach Anspruch 3,
**dadurch gekennzeichnet,**
**dass**, bezogen auf den jeweiligen Zeitraum (T1+T2), zu dem das jeweilige Schaltelement (7) durchgeschaltet ist, der Anteil, zu dem die Steuereinrichtung (8) das dritte Potenzial (P3) an die Steuerelektrode (11) des jeweiligen Schaltelements (7) anschaltet, größer als der Anteil ist, zu dem die Steuereinrichtung (8) das zweite Potenzial (P2) an die Steuerelektrode (11) des jeweiligen Schaltelements (7) anschaltet.

5. Betriebsverfahren nach einem der obigen Ansprüche,
**dadurch gekennzeichnet,**
**dass**, bezogen auf das erste Potenzial (P1), das dritte Potenzial (P3) um mindestens 10 % größer als das zweite Potenzial (P2) ist.

6. Betriebsverfahren nach einem der obigen Ansprüche,
**dadurch gekennzeichnet,**
**dass**, bezogen auf das erste Potenzial (P1), das dritte Potenzial (P3) um maximal 100 % größer als das zweite Potenzial (P2) ist.

7. Betriebsverfahren nach einem der obigen Ansprüche,
**dadurch gekennzeichnet,**
**dass** das dritte Potenzial (P3) um 3 V bis 10 V größer als das zweite Potenzial (P2) ist.

8. Betriebsverfahren nach einem der obigen Ansprüche,
**dadurch gekennzeichnet,**
**dass** das zweite Potenzial (P2) um 8 V bis 30 V größer als das erste Potenzial (P1) ist.

9. Steuerprogramm für eine Steuereinrichtung (8) eines Umrichters (1), wobei das Steuerprogramm Maschinencode (10) aufweist, der von der Steuereinrichtung (8) abarbeitbar ist, wobei die Abarbeitung des Maschinencodes (10) durch die Steuereinrichtung (8) bewirkt, dass die Steuereinrichtung (8) den Umrichter (1) gemäß einem Betriebsverfahren nach einem der obigen Ansprüche betreibt.

10. Steuereinrichtung für einen Umrichter (1), wobei die Steuereinrichtung mit einem Steuerprogramm (9) nach Anspruch 9 programmiert ist, so dass die Steuereinrichtung den Umrichter (1) gemäß einem Betriebsverfahren nach einem der Ansprüche 1 bis 8 betreibt.

11. Umrichter, wobei der Umrichter als Halbleiter-Bauelemente ausgebildete Schaltelemente (7) aufweist, über die eine Last (5) gespeist wird, wobei der Umrichter eine Steuereinrichtung (8) nach Anspruch 10 aufweist, welche den Umrichter gemäß einem Betriebsverfahren nach einem der Ansprüche 1 bis 8 betreibt.

FIG 1

FIG 2

# FIG 3

## FIG 4

## FIG 5

## FIG 6

FIG 7

FIG 8

FIG 9

FIG 10

12"

12'

12

t

FIG 11

t

FIG 12

P

T1

T2

20V

15V

$$\alpha = \frac{T2}{T1+T2}$$

0V

t

FIG 13

12"

12'

12

t

## FIG 14

## FIG 15

## FIG 16

Europäisches Patentamt
European Patent Office
Office européen des brevets

# EUROPÄISCHER RECHERCHENBERICHT

Nummer der Anmeldung

EP 18 17 4871

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | DE 10 2016 201923 A1 (SIEMENS AG [DE]) 10. August 2017 (2017-08-10) * Abbildungen 1,2,3 * * Absätze [0017], [0029] - [0049] * ----- | 1-11 | INV. H02M1/08 H02M1/32 H03K17/06 |
| Y | DE 11 2014 001238 T5 (FUJI ELECTRIC CO LTD [JP]) 14. Januar 2016 (2016-01-14) * Zusammenfassung; Abbildungen 1-3 * * Absätze [0038], [0041] * ----- | 1,2,5-7, 9-11 | ADD. H02M7/5387 H02M1/00 H03K17/08 |
| Y | EP 3 280 052 A1 (GE ENERGY POWER CONVERSION TECH LTD [GB]) 7. Februar 2018 (2018-02-07) * Abbildungen 1,5,6,7 * * Absätze [0076] - [0090] * ----- | 1,3-11 | |
| Y | EP 3 206 286 A1 (GE ENERGY POWER CONVERSION TECHNOLOGY LTD [GB]) 16. August 2017 (2017-08-16) * Absätze [0068] - [0077] * ----- | 1,2,5-11 | |
| Y | DE 10 2007 004006 A1 (HITACHI LTD [JP]) 11. Oktober 2007 (2007-10-11) * Abbildungen 1,4,13 * * Absätze [0005], [0007], [0025], [0026], [0028], [0029] * ----- | 1,2,9-11 | RECHERCHIERTE SACHGEBIETE (IPC) H02M H03K |

Der vorliegende Recherchenbericht wurde für alle Patentansprüche erstellt

| Recherchenort | Abschlußdatum der Recherche | Prüfer |
|---|---|---|
| Den Haag | 4. Dezember 2018 | Kail, Maximilian |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 18 17 4871

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

04-12-2018

| Im Recherchenbericht angeführtes Patentdokument | Datum der Veröffentlichung | Mitglied(er) der Patentfamilie | Datum der Veröffentlichung |
|---|---|---|---|
| DE 102016201923 A1 | 10-08-2017 | DE 102016201923 A1<br>EP 3414831 A1<br>WO 2017137107 A1 | 10-08-2017<br>19-12-2018<br>17-08-2017 |
| DE 112014001238 T5 | 14-01-2016 | CN 105103427 A<br>DE 112014001238 T5<br>JP 6070853 B2<br>JP WO2015045531 A1<br>US 2016036316 A1<br>WO 2015045531 A1 | 25-11-2015<br>14-01-2016<br>01-02-2017<br>09-03-2017<br>04-02-2016<br>02-04-2015 |
| EP 3280052 A1 | 07-02-2018 | EP 3280052 A1<br>US 2018034358 A1 | 07-02-2018<br>01-02-2018 |
| EP 3206286 A1 | 16-08-2017 | CN 107070191 A<br>EP 3206286 A1<br>US 2017302189 A1 | 18-08-2017<br>16-08-2017<br>19-10-2017 |
| DE 102007004006 A1 | 11-10-2007 | DE 102007004006 A1<br>JP 4816182 B2<br>JP 2007259576 A<br>US 2007221994 A1 | 11-10-2007<br>16-11-2011<br>04-10-2007<br>27-09-2007 |

EPO FORM P0461

Für nähere Einzelheiten zu diesem Anhang : siehe Amtsblatt des Europäischen Patentamts, Nr.12/82